# FASCICULE DE BREVET EUROPEEN

(11) **EP 3 587 343 B1**
(45) Date de publication et mention de la délivrance du brevet: **16.06.2021**
(21) Numéro de dépôt: 19181163.7
(22) Date de dépôt: 19.06.2019
(51) Int. Cl.: B81C 1/00

(54) **PROCEDE DE REALISATION D'UN DISPOSITIF AU MOINS PARTIELLEMENT TRANSPARENT INTEGRANT UNE STRUCTURE DE TYPE CONDENSATEUR**
HERSTELLUNGSVERFAHREN EINER VORRICHTUNG, DIE ZUMINDEST TEILWEISE TRANSPARENT IST UND EINE STRUKTUR VOM TYP KONDENSATOR UMFASST
METHOD FOR MANUFACTURING AN AT LEAST PARTIALLY TRANSPARENT DEVICE INCLUDING A STRUCTURE SUCH AS A CAPACITOR

(30) Priorité: 22.06.2018 FR 1855592
(43) Date de publication de la demande: 01.01.2020
(73) Titulaire: Commissariat à l'énergie atomique et aux énergies alternatives, 75015 Paris (FR)
(72) Inventeur: LE RHUN, Gwenaël, 38054 GRENOBLE CEDEX 09 (FR)
(74) Mandataire: Brevalex

(56) Documents cités:
- US-A1- 2013 322 663
- US-A1- 2018 082 989

## Description

### DOMAINE TECHNIQUE ET ART ANTÉRIEUR

L'invention concerne un procédé de réalisation d'un dispositif au moins partiellement transparent intégrant une structure de type condensateur. L'invention s'applique avantageusement à la réalisation de dispositifs transducteurs piézoélectriques et/ou pyroélectriques et/ou ferroélectriques, tels que des actionneurs et des capteurs, de condensateurs MIM (Métal - Isolant - Métal) ou coplanaires, ou de mémoires ferroélectriques, au moins partiellement transparents.

Lors de la réalisation de composants MEMS (microsystème électromécanique) et/ou NEMS (nanosystème électromécanique) ou de composants microélectroniques, des étapes de dépôt de couches, minces ou épaisses, sur un substrat sont mises en œuvre. Le substrat sur lequel ces couches sont déposées peut comporter du semi-conducteur, comme par exemple du silicium, ou du verre, ou du saphir, ou un matériau polymère.

Pour certaines applications, par exemple optiques ou haptiques, les dispositifs réalisés, correspondant par exemple à des condensateurs, des transducteurs électromécaniques, etc., sont avantageusement transparents (totalement ou partiellement). Il convient alors d'utiliser un substrat au moins partiellement transparent, par exemple en verre ou en polymère et qui peut être de qualité variable suivant l'application envisagée, comme par exemple pour la réalisation de dalles optiques pour téléphones ou tablettes électroniques. Les matériaux utilisés par exemple pour la réalisation des électrodes ou les matériaux fonctionnels des dispositifs ou bien ceux formant des couches élastiques, sont également au moins partiellement transparents.

Les procédés technologiques classiquement utilisés sur silicium ne sont toutefois pas toujours adaptés pour de tels substrats au moins partiellement transparents. Par exemple, la température de dépôt et/ou de recuit des matériaux à déposer sur le substrat peut ne pas être compatible avec le substrat. Ainsi, lorsque le substrat utilisé comprend au moins un matériau polymère, les températures de dépôt et/ou de recuit des couches formées sur un tel substrat ne doivent pas dépasser environ 150°C, sous peine de l'endommager.

D'autre part, le choix des matériaux au moins partiellement transparents est assez restreint, d'autant qu'ils doivent être compatibles entre eux. C'est le cas par exemple lorsqu'un matériau fonctionnel doit être réalisé par croissance sur un matériau d'électrode. Il est par exemple très compliqué de faire croître une couche d'AIN avec une bonne qualité cristalline sur une électrode au moins partiellement transparente.

Le document « Transparent piezoelectric transducers for large area ultrasonic actuators » de D. Sette et al., IEEE MEMS 2017, Las Vegas, NV, USA, 22-26 janvier 2017, décrit un exemple de réalisation d'un transducteur piézoélectrique transparent à partir d'un substrat de verre. Dans ce dispositif, du PZT (titanate zirconate de plomb) cristallin est déposé sur une couche de SiO₂ par l'intermédiaire d'une couche de TiO₂ formée au préalable sur la couche de SiO₂ et permettant d'éviter la formation de fissures dans le PZT. Le PZT ainsi réalisé ne présente toutefois pas de texturation, c'est-à-dire d'orientation cristallographique préférentielle, ce qui est pourtant nécessaire pour optimiser les propriétés piézoélectriques du PZT. De plus, le TiO₂ présent entre le PZT et la couche de SiO₂ engendre une baisse de la transmittance lumineuse au sein de l'empilement du dispositif. Enfin, la structure du dispositif décrit dans ce document ne permet pas d'avoir une électrode enterrée sous la couche de PZT, seules des électrodes interdigitées présentes en surface du PZT étant possibles.

Pour répondre à une partie de ces problèmes, il existe des procédés de transfert de couches de matériaux depuis un substrat donneur, sur lequel une ou plusieurs couches de matériaux à transférer sont réalisées initialement, sur un substrat receveur. Etant donné que les étapes de dépôt et/ou de recuit nécessaires à la réalisation de cette ou ces couches sont mises en œuvre avant leur transfert sur le substrat receveur, le matériau du substrat receveur n'est pas endommagé par les températures mises en jeu lors du dépôt et/ou du recuit des matériaux sur le substrat donneur.

Un de ces procédés de transfert consiste à former une interface de clivage par implantation ionique dans le substrat donneur. Le substrat donneur, sur lequel la ou les couches à transférer ont été réalisées, est ensuite solidarisé au substrat receveur. Une séparation des deux substrats est ensuite réalisée, au niveau de l'interface de clivage formée dans le substrat donneur, par traitement thermique. Un tel procédé de transfert permet toutefois de ne transférer que des couches d'épaisseur relativement faible, au plus d'environ 1 micron d'épaisseur. De plus, l'implantation ionique peut endommager la ou les couches de matériaux devant être traversées par le faisceau ionique utilisé. En outre, une étape de traitement de surface post-transfert doit être mise en œuvre au niveau de l'interface de clivage.

Un autre procédé de transfert consiste à former la ou les couches souhaitées sur le substrat donneur, à reporter ensuite sur le substrat receveur l'ensemble formé de la ou des couches souhaitées et du substrat donneur, puis à graver le substrat donneur depuis sa face arrière (face opposée à celle sur laquelle se trouve(nt) la ou les couches à transférer). L'inconvénient d'un tel procédé est que le substrat donneur est détruit et qu'il ne peut donc pas être réutilisé pour réaliser un autre dispositif. De plus, la gravure du substrat donneur est une étape lourde, longue et coûteuse, et qui nécessite de prévoir un arrêt propre sur l'empilement à transférer, par exemple par une couche d'arrêt de gravure et/ou de gravure sélective.

Le document US 2013/322663 A1 décrit un dispositif acoustique actif comprenant un substrat transparent 2 sur lequel sont déposées des électrodes transparentes 3, 5 et une couche piézoélectrique transparente 4. Le document US 2018/0082989 A1 décrit plusieurs procédés de réalisation de circuits intégrés 3D, incluant notamment la réalisation d'interfaces de clivage formées par implantation ionique.

### EXPOSÉ DE L'INVENTION

Un but de la présente invention est de proposer un procédé de réalisation d'un dispositif au moins partiellement transparent intégrant une structure de type condensateur et ne présentant pas les inconvénients décrits ci-dessus pour les procédés de l'art antérieur.

Pour cela, la présente invention propose un procédé de réalisation d'un dispositif au moins partiellement transparent, comportant au moins :
- réalisation, sur une face d'un premier substrat, de première et deuxième couches de séparation disposées l'une contre l'autre et telles que la première couche de séparation soit disposée entre le premier substrat et la deuxième couche de séparation ;
- réalisation, sur la deuxième couche de séparation, d'au moins une couche fonctionnelle au moins partiellement transparente ;
- solidarisation de la couche fonctionnelle à un deuxième substrat au moins partiellement transparent, formant un empilement de différents matériaux ;
- séparation mécanique au niveau d'une interface entre les première et deuxième couches de séparation, telle que la première couche de séparation reste solidaire du premier substrat et que la deuxième couche de séparation reste solidaire de la couche fonctionnelle ;
- suppression de la deuxième couche de séparation ;
- réalisation d'au moins une première couche d'électrode au moins partiellement transparente sur la couche fonctionnelle ;
dans lequel les matériaux de l'empilement sont choisis tels que l'interface entre les première et deuxième couches de séparation correspond à celle, parmi toutes les interfaces de l'empilement, ayant la plus faible force d'adhérence, et dans lequel :
- l'une des première et deuxième couches de séparation comporte au moins du SiO₂ et/ou du nitrure de silicium (tel que du SiN et/ou du Si₃N₄), et l'autre des première et deuxième couches de séparation comporte au moins un métal noble, et/ou
- le procédé comporte, entre l'étape de réalisation des première et deuxième couches de séparation et l'étape de solidarisation, la mise en œuvre d'au moins une étape réduisant une force d'adhérence initiale de l'interface entre les première et deuxième couches de séparation.

Dans ce procédé, l'interface au niveau de laquelle la séparation mécanique est réalisée peut être définie au préalable par un choix judicieux des matériaux des première et deuxième couches de séparation engendrant naturellement une faible force d'adhérence à cette interface. En utilisant d'un côté un métal noble et de l'autre du SiO₂ et/ou du nitrure de silicium pour former les première et deuxième couches de séparation, une faible force d'adhérence est obtenue à l'interface de ces deux couches de séparation, sans avoir à mettre en œuvre d'étape spécifique. Ainsi, après avoir solidarisé les deux substrats l'un à l'autre, la séparation mécanique réalisée au niveau de l'interface entre les première et deuxième couches de séparation ne dégrade pas les autres couches car c'est l'interface entre les première et deuxième couches de séparation qui présente la plus faible force d'adhérence parmi toutes les interfaces de l'empilement obtenu en solidarisant les premier et deuxième substrats entre eux.

En variante ou en complément de la réalisation des première et deuxième couches de séparation à partir d'un métal noble et de SiO₂ et/ou de nitrure de silicium, la force d'adhérence à l'interface entre les première et deuxième couches de séparation peut être réduite en mettant en œuvre une étape spécifique, comme par exemple la formation de cavités à cette interface.

Le métal utilisé pour former l'une des première et deuxième couches de séparation peut correspondre à un métal résistant à l'oxydation.

La couche de séparation comportant du SiO₂ et/ou du nitrure de silicium peut correspondre à une couche de SiO₂ ou de nitrure de silicium, ou à un empilement de SiO₂ et de nitrure de silicium.

Ce procédé a également pour avantage d'être compatible avec n'importe quelle épaisseur de couche(s), c'est-à-dire une ou plusieurs couches minces et/ou épaisses, destinées à faire partie du dispositif, notamment la couche fonctionnelle et éventuellement une couche d'électrode destinée à former une électrode enterrée du dispositif.

De plus, à l'issue de la séparation mécanique à l'interface entre les première et deuxième couches de séparation, le premier substrat n'est pas détruit et peut être réutilisé, par exemple pour réaliser un nouveau dispositif.

Ce procédé a également pour avantage de ne pas exposer le deuxième substrat au moins partiellement transparent à des températures importantes pour la réalisation des différentes couches de matériaux du dispositif, et de ne pas nécessiter la mise en œuvre d'une gravure du premier substrat qui est très contraignante ou d'une implantation ionique pouvant endommager certaines couches de matériaux du dispositif.

Ce procédé ne présente pas non plus les contraintes rencontrées lorsque le dispositif est réalisé sans transfert de couche. Ce procédé ne limite pas le choix des matériaux au moins partiellement transparents pouvant être utilisés, permet l'obtention d'un matériau fonctionnel de bonne qualité, d'une bonne transmittance et le dispositif peut comporter une électrode enterrée sous la couche fonctionnelle.

Le dispositif peut correspondre avantageusement à un actionneur et/ou un capteur de type piézoélectrique, à un capteur pyroélectrique, à un dispositif de récupération d'énergie vibratoire, à une mémoire ferroélectrique, ou encore un condensateur MIM ou coplanaire.

Dans l'ensemble du document, le terme « sur » est utilisé sans distinction de l'orientation dans l'espace de l'élément auquel ce rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

L'expression « toutes les interfaces de l'empilement » désigne toutes les interfaces formées entre deux couches successives (disposées l'une directement contre l'autre) de l'empilement.

Dans tout le document, un élément au moins partiellement transparent désigne un élément présentant, pour des longueurs d'onde comprises entre environ 350 nm et 1 µm, un taux de transmission, ou transmittance, supérieur ou égal à environ 60 %, c'est-à-dire pouvant être traversé par au moins 60 % des faisceaux lumineux de longueur d'onde comprise dans la gamme [350 nm ; 1 µm]. La transmittance peut être mesurée comme décrit par exemple dans le document R.Mavrodineanu, « An Accurate Spectrophotometer for Measuring the Transmittance of Solid and Liquid Materials », Journal of Research of the National Bureau of Standards - A. Physics and Chemistry, Vol. 76A, N°5, Sept-Oct 1972.

Un dispositif transducteur désigne un dispositif apte à convertir une première grandeur physique en une deuxième grandeur physique de nature différente de celle de la première grandeur physique (par exemple conversion d'une force mécanique en un signal électrique, ou inversement).

Le métal noble correspond à l'un ou plusieurs des matériaux suivants : platine (Pt), or (Au), argent (Ag), rhodium (Rh), osmium (Os), palladium (Pd), ruthénium (Ru), iridium (Ir).

Lorsque le métal noble est destiné à être exposé à de forts budgets thermiques, par exemple jusqu'à une température égale à environ 850°C, ce métal noble comporte avantageusement du platine et/ou du palladium. Lorsque le métal noble est destiné à être exposé à des températures moins importantes, comme par exemple des températures inférieures ou égales à environ 400°C, les autres métaux nobles (Au, Ag, Rh, Os, Ru, Ir) peuvent être utilisés pour former cette couche de métal noble.

La force d'adhérence de l'interface entre les première et deuxième couches de séparation peut être inférieure ou égale à environ 1,5 J/m², ou de préférence inférieure ou égale à environ 1 J/m². A titre d'exemple, la force d'adhérence entre les première et deuxième couches de séparation avec l'une comprenant du SiO₂ et l'autre du platine est égale à environ 1J/m².

La force d'adhérence entre deux couches de matériaux peut être mesurée par la méthode dite d'insertion de lame décrite par exemple dans le document W. P. Mazsara et al., « Bonding of silicon wafers for silicon-on-insulator », Journal of Applied Physics 64, p. 4943, 1988).

Le dispositif réalisé comporte une structure de type condensateur, la couche fonctionnelle pouvant être destinée à être traversée par un courant circulant entre au moins deux électrodes formées à partir de la première couche d'électrode (avec par exemple des électrodes interdigitées réalisées sur une face de la couche fonctionnelle) ou à partir de la première couche d'électrode et d'une deuxième couche d'électrode, avec la couche fonctionnelle disposée entre les première et deuxième couches d'électrode.

L'expression « couche fonctionnelle » désigne une couche de matériau apte à remplir, avec la ou les couches d'électrodes, la fonction du dispositif réalisé. Par exemple, lorsque le dispositif est un transducteur, la couche fonctionnelle est apte à convertir une première grandeur physique en une deuxième grandeur physique de nature différente de celle de la première grandeur physique. Lorsque le dispositif est un condensateur, la couche fonctionnelle correspond à la couche diélectrique d'isolation du condensateur. Lorsque le dispositif est une mémoire ferroélectrique, la couche fonctionnelle correspond à la couche de matériau ferroélectrique remplissant la fonction de mémorisation.

La couche fonctionnelle peut être en contact direct avec la première couche d'électrode.

Le premier substrat peut comporter du semi-conducteur, par exemple du silicium.

De manière avantageuse, le métal noble peut comporter du platine.

L'étape de la solidarisation peut être mise en œuvre :
- par l'intermédiaire d'au moins une couche adhésive au moins partiellement transparente réalisée sur la couche fonctionnelle et/ou sur le deuxième substrat, ou
- par collage direct, ou collage moléculaire, entre une première couche de collage au moins partiellement transparente réalisée sur la couche fonctionnelle, et une deuxième couche de collage au moins partiellement transparente réalisée sur le deuxième substrat.

Lorsque l'étape de solidarisation est mise en œuvre par l'intermédiaire de la couche adhésive réalisée sur la couche fonctionnelle et/ou sur le deuxième substrat, il est possible d'avoir une ou plusieurs autres couches de matériaux présentes entre la couche adhésive et la couche fonctionnelle ou entre la couche adhésive et le deuxième substrat.

Lorsque l'étape de solidarisation est mise en œuvre par collage direct, ou collage moléculaire, entre les première et deuxième couches de collage, il est possible d'avoir une ou plusieurs autres couches de matériaux présentes entre la première couche de collage et la couche fonctionnelle et/ou entre la deuxième couche de collage et le deuxième substrat.

La couche adhésive peut comporter une colle polymère, ou les première et deuxième couches de collage peuvent comporter du SiO₂.

La couche fonctionnelle peut comporter au moins un matériau pyroélectrique et/ou piézoélectrique et/ou ferroélectrique et/ou diélectrique.

Le procédé est particulièrement avantageux lorsque le matériau pyroélectrique et/ou piézoélectrique et/ou ferroélectrique et/ou diélectrique comporte du plomb, comme par exemple lorsque ce matériau correspond à du PZT (Titano-Zirconate de Plomb) ou un matériau de la même famille que le PZT, car il permet dans ce cas de s'affranchir des contraintes liées à l'intégration de ce matériau comportant le plomb, telles que le budget thermique nécessaire à son dépôt (qui n'est pas compatible avec un substrat de verre ou encore un substrat comprenant un polymère). Par exemple, lorsque le matériau pyroélectrique et/ou piézoélectrique et/ou ferroélectrique et/ou diélectrique correspond à matériau à structure cristalline pérovskite comme par exemple du PZT, la cristallisation / densification de ce matériau nécessite d'atteindre des températures supérieures à environ 500°C, voire 700°C, ce qui n'est pas compatible avec un substrat au moins partiellement transparent tel qu'un substrat de verre ou encore un substrat de polymère.

De même, lorsque le matériau de la couche fonctionnelle comporte de l'AIN, ce procédé est avantageux car il évite l'exposition du deuxième substrat aux températures de recristallisation de l'AIN (de l'ordre de 300°C).

Le procédé peut être tel que :
- le matériau pyroélectrique et/ou piézoélectrique et/ou ferroélectrique et/ou diélectrique comporte du plomb, et peut correspondre à du PZT ;
- ladite une des première et deuxième couches de séparation comporte du SiO₂ ;
- ladite au moins une étape réduisant la force d'adhérence initiale de l'interface entre les première et deuxième couches de séparation comporte la mise en œuvre d'au moins un traitement thermique formant, à l'interface entre les première et deuxième couches de séparation, un alliage de plomb et de SiO₂ en phase liquide, puis d'un refroidissement formant des cavités à l'interface entre les première et deuxième couches de séparation.

De telles cavités contribuent, seules ou en complément des matériaux choisis pour former les première et deuxième couches de séparation, à l'obtention de la faible force d'adhérence à l'interface entre les première et deuxième couches de séparation.

Le procédé peut être tel que :
- la première couche de séparation comporte le métal noble, la deuxième couche de séparation comporte du SiO₂ et/ou du nitrure de silicium, et la couche fonctionnelle comporte de l'AlN, ou
- la première couche de séparation comporte du SiO₂ et/ou du nitrure de silicium, la deuxième couche de séparation comporte le métal noble et la couche fonctionnelle comporte du PZT.

Le procédé peut comporter en outre, entre la réalisation de la couche fonctionnelle et la solidarisation de la couche fonctionnelle au deuxième substrat, la réalisation d'au moins une deuxième couche d'électrode au moins partiellement transparente sur la couche fonctionnelle, et, lors de l'étape de solidarisation, la deuxième couche d'électrode peut être disposée entre le deuxième substrat et la couche fonctionnelle. Le dispositif obtenu à l'issu du procédé a donc une électrode enterrée formée par cette deuxième couche d'électrode et peut avoir une structure du type de celle d'un condensateur MIM, c'est-à-dire avoir la couche fonctionnelle disposée entre les première et deuxième couches d'électrode. La réalisation d'un tel dispositif avec ce procédé a pour avantage de ne pas avoir à réaliser la croissance du matériau de la couche fonctionnelle sur l'une des couches d'électrode car la qualité d'une couche d'électrode sur laquelle un matériau fonctionnel est réalisé est alors critique pour la qualité du matériau fonctionnel ainsi obtenu.

La couche fonctionnelle peut être disposée entre et en contact direct avec les première et deuxième couches d'électrode.

En variante, le procédé peut comporter en outre, après la réalisation de la première couche d'électrode, une gravure de la première couche d'électrode selon un motif de peignes interdigités et formant les électrodes du dispositif. Le dispositif obtenu a dans ce cas une structure du type de celle d'un condensateur coplanaire avec ses électrodes formées sur une seule face de la couche fonctionnelle.

Le procédé peut comporter en outre, après l'étape de solidarisation, la réalisation d'au moins une cavité dans le deuxième substrat, à travers une face opposée à celle sur laquelle la couche fonctionnelle est solidarisée. Une telle cavité peut servir à former une membrane, par exemple lorsque le dispositif est un transducteur électromécanique, notamment piézoélectrique de type PMUT (Transducteur Ultrasonore Micro-usiné Piézoélectrique) ou un dispositif de récupération d'énergie.

Le deuxième substrat peut comporter au moins un matériau polymère, et l'étape de solidarisation peut être mise en œuvre à une température inférieure ou égale à environ 150°C. A titre d'exemples non limitatifs, une solidarisation à une température inférieure à environ 150°C peut correspondre à un collage par l'intermédiaire d'une couche de colle comprenant un matériau polymère, ou encore un collage direct oxyde - oxyde.

L'invention concerne également un dispositif au moins partiellement transparent comportant au moins :
- un substrat au moins partiellement transparent ;
- des première et deuxième couches d'électrode au moins partiellement transparentes disposées du côté d'une première face du substrat et comprenant chacune au moins un matériau électriquement conducteur ;
- une couche fonctionnelle au moins partiellement transparente, disposée entre et en contact direct avec les première et deuxième couches d'électrode ;
- au moins une cavité traversant au moins une partie du substrat depuis une deuxième face du substrat opposée à la première face.

Le dispositif peut être tel que :
- le substrat comporte du verre et/ou au moins un matériau polymère, et/ou
- les première et deuxième couches d'électrodes comportent de l'ITO et/ou ZnO dopé avec du Ga et/ou du ZnO dopé avec de l'Al, et/ou
- la couche fonctionnelle comporte au moins l'un des matériaux suivants : PZT, PMN-PT, KNN, NBT-BT, BaTiO₃.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1D représentent les étapes d'un procédé de réalisation d'un dispositif au moins partiellement transparent selon un premier mode de réalisation ;
- la figure 2 représente un dispositif au moins partiellement transparent obtenu par la mise en œuvre d'un procédé de réalisation selon une variante du premier mode de réalisation ;
- les figures 3A à 3D représentent les étapes d'un procédé de réalisation d'un dispositif au moins partiellement transparent selon un deuxième mode de réalisation ;
- la figure 4 représente un dispositif au moins partiellement transparent obtenu par la mise en œuvre d'un procédé de réalisation selon une variante du deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

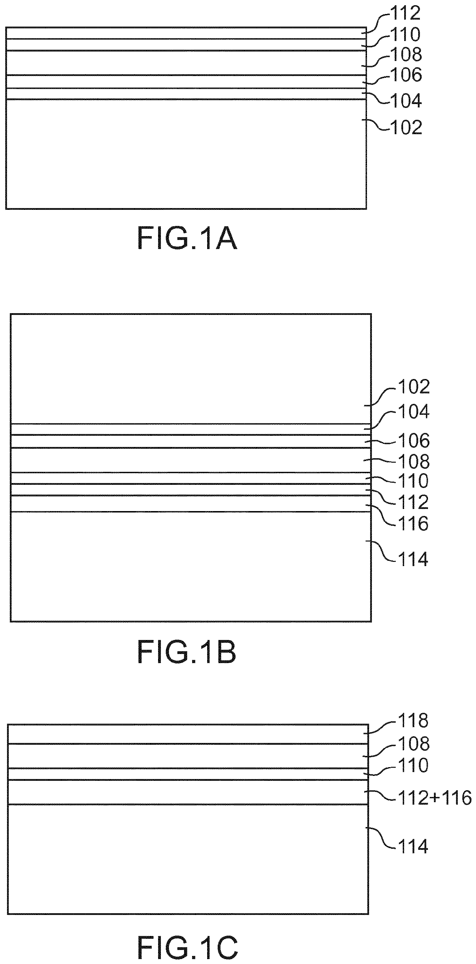

On se réfère tout d'abord aux figures 1A à 1D qui représentent les étapes d'un procédé de réalisation d'un dispositif 100 au moins partiellement transparent selon un premier mode de réalisation.

Comme représenté sur la figure 1A, un premier substrat 102, également appelé substrat donneur, est utilisé pour réaliser au moins une partie des couches du dispositif 100. Le premier substrat 102 correspond ici à un substrat de semi-conducteur, comprenant par exemple du silicium, et dont l'épaisseur est par exemple comprise entre environ 100 µm et 1 mm.

Une interface de faible force d'adhérence est tout d'abord formée sur le premier substrat 102. Dans ce premier mode de réalisation, cette interface est formée grâce à une première couche de séparation 104 comprenant ici au moins un métal noble et une deuxième couche de séparation 106 comprenant au moins du SiO₂ et/ou du nitrure de silicium tel que du SiN et/ou du Si₃N₄. L'interface de faible force d'adhérence correspond à l'interface entre ces deux couches de séparation 104, 106, et est obtenue grâce la nature des matériaux des couches de séparation 104, 106 qui n'adhèrent que faiblement l'un à l'autre.

Le métal noble de la première couche de séparation 104 comporte au moins l'un des éléments suivants : platine, or, argent, rhodium, osmium, palladium, ruthénium, iridium. L'épaisseur de la première couche de séparation 104 est par exemple comprise entre environ 1 nm et 200 nm. Le matériau de la deuxième couche de séparation 106 peut correspondre avantageusement à du SiO₂.L'épaisseur de la deuxième couche de séparation 106 est par exemple comprise entre environ 1 nm et 20 µm. La première couche de séparation 104 qui comporte le métal noble peut être formée par dépôt, par exemple PVD (dépôt physique en phase vapeur). La deuxième couche de séparation 106 qui comporte le SIO₂ et/ou le nitrure de silicium peut également être formée par dépôt PVD.

Une couche fonctionnelle 108 au moins partiellement transparente est réalisée, par exemple par pulvérisation cathodique, sur la deuxième couche de séparation 106. Dans le premier mode de réalisation décrit ici, le dispositif 100 correspond à un dispositif de transduction piézoélectrique au moins partiellement transparent, et la couche 108 comporte donc un matériau piézoélectrique au moins partiellement transparent, comme par exemple de l'AIN, éventuellement dopé (par exemple avec du Sc) pour optimiser ses propriétés piézoélectriques, ou du ZnO. L'épaisseur de la couche 108 est par exemple comprise entre environ 1 nm et 100 µm. En outre, du fait que le matériau de la couche 108 est formé sur la deuxième couche de séparation 106, ce matériau de la couche 108 a une texturation optimale qui se traduira *in fine* par de bonnes performances de transduction du dispositif 100.

En variante, la couche 108 peut comporter du PZT ou un matériau de la même famille que le PZT, pouvant également être dopé par exemple par du La, du Nb, du Mn, etc., ou encore du PMN-PT ((1 - x)Pb(Mg_{1/3}Nb_{2/3})O₃ - xPbTiO₃), du KNN ((K,Na)NbO₃), du NBT-BT ((Na_{0,5}Bi_{0,5})TiO₃-BaTiO₃), du BaTiO₃, ou tout autre matériau de transduction au moins partiellement transparent. Le matériau de la couche 108 est par exemple déposé par voie sol-gel ou par pulvérisation cathodique. Dans ce cas, la première couche de séparation 104 comporte de préférence le SiO₂ et/ou le nitrure de silicium, et la deuxième couche de séparation 106 comporte de préférence le métal noble afin que le matériau de transduction soit formé sur le métal noble, conférant une texture (orientation cristallographique préférentielle) optimale au matériau de transduction.

Une couche d'électrode 110 au moins partiellement transparente est formée, par exemple par dépôt, sur la couche 108. Cette couche d'électrode 110 est destinée à former l'une des électrodes du dispositif 100. Cette couche 110 comporte un matériau électriquement conducteur, par exemple un oxyde métallique, et au moins partiellement transparent, comme par exemple de l'ITO (oxyde d'indium et d'étain), du ZNO dopé avec du Ga (également appelé GZO), ou du ZNO dopé avec de l'Al (également appelé AZO) ou tout autre matériau conducteur au moins partiellement transparent comme par exemple un métal très fin (épaisseur comprise par exemple entre environ 1 nm et 10 nm). L'épaisseur de la couche 110 est par exemple comprise entre environ 1 nm et 200 nm.

Une première couche de collage 112 est ensuite réalisée, par exemple par dépôt, sur la couche d'électrode 110. Cette première couche de collage 112 est destinée à servir à la mise en œuvre d'un collage direct, ou collage moléculaire, avec une deuxième couche de collage permettant le report des couches 108 et 110 sur un deuxième substrat au moins partiellement transparent destiné à former le support du dispositif 100. La première couche de collage 112 a des propriétés adaptées à la mise en œuvre d'un collage direct : très faible rugosité, matériau adapté, etc. Cette première couche de collage 112 comporte par exemple du SiO₂, et une épaisseur par exemple comprise entre environ 1 nm et 20 µm.

Comme représenté sur la figure 1B, le premier substrat 102 et les couches 104, 106, 108, 110 et 112 formées sur le premier substrat 102 sont reportés sur un deuxième substrat 114 au moins partiellement transparent et sur lequel est formée au préalable une deuxième couche de collage 116 adaptée pour la mise en œuvre d'un collage direct avec la première couche de collage 112. La deuxième couche de collage 116 comporte par exemple du SiO₂ et est formée par dépôt PVD.

Le deuxième substrat 114 comporte au moins un matériau partiellement transparent correspondant par exemple à du verre, ou bien un matériau polymère. Dans le cas d'un deuxième substrat 114 souple / flexible, celui-ci peut être disposé sur un support rigide pendant le report du premier substrat 102 et des couches 104 - 112 sur celui-ci. L'épaisseur du deuxième substrat 114 est par exemple égale à plusieurs centaines de microns. Lorsque le deuxième substrat 114 correspond à un substrat en matériau polymère, son épaisseur est par exemple comprise entre environ 1 µm et 1 mm.

Au sein de l'empilement ainsi obtenu, l'interface de faible force d'adhérence formée entre les couches de séparation 104, 106 correspond, parmi toutes les interfaces de l'empilement, à celle qui présente la plus faible force d'adhérence entre deux couches successives de l'empilement.

Une séparation mécanique est ensuite réalisée au niveau de cette interface de faible force d'adhérence entre les couches de séparation 104, 106. Cette séparation mécanique est par exemple réalisée en introduisant une lame entre les deux wafers. A l'issue de cette séparation mécanique, l'empilement restant conservé comporte le deuxième substrat 114 sur lequel les couches 108 et 110 sont solidarisées par l'intermédiaire des couches de collage 112 + 116. Le premier substrat 102 restant peut être réutilisé ultérieurement, par exemple pour la réalisation d'un autre dispositif 100. Le matériau et l'épaisseur des couches de collage 112, 116 sont choisis tels que l'assemblage de ces deux couches de collage forme ensemble un élément au moins partiellement transparent.

La deuxième couche de séparation 106 est retirée après l'étape de séparation, par exemple par gravure sèche RIE (gravure ionique réactive). Une autre couche d'électrode 118 au moins partiellement transparente, par exemple similaire à la couche d'électrode 110, est ensuite réalisée sur la couche 108 (voir figure 1C).

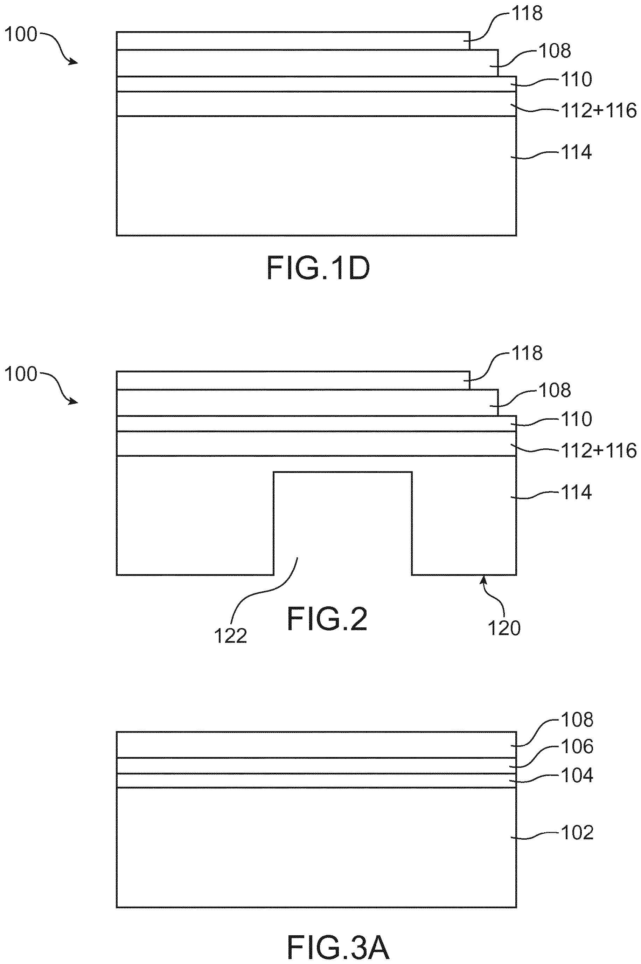

Le dispositif 100 est ensuite achevé en structurant, par la mise en œuvre d'étapes de lithographie et gravure, les couches 110, 108 et 118 selon le motif souhaité pour le dispositif 100. Sur la figure 1D, les couches 108 et 118 sont gravées afin que des parties de chacune de ces couches soient accessibles électriquement, c'est-à-dire non recouvertes par les autres couches.

Dans le premier mode de réalisation précédemment décrit, la première couche de séparation 104 comporte le métal noble et la deuxième couche de séparation 106 comporte le SiO₂ et/ou le nitrure de silicium. Selon une variante, il est possible que la première couche de séparation 104 comporte le SiO₂ et/ou le nitrure de silicium, et que la deuxième couche de séparation 106 comporte le métal noble. Dans ce cas, la première couche de séparation 104, lorsqu'elle comporte du SiO₂, est par exemple réalisée par oxydation thermique de la face supérieure du premier substrat 102 lorsque ce premier substrat 102 comporte du silicium.

Dans le premier mode de réalisation précédemment décrit, la solidarisation du premier substrat 102 et des couches 104- 110 avec le deuxième substrat 114 est réalisée par la mise en œuvre d'un collage direct entre les deux couches de collage 112, 116 formées au préalable sur chacune des parties du dispositif 100 à solidariser. En variante, cette solidarisation peut être obtenue en formant sur la première couche d'électrode 110 et/ou sur le deuxième substrat 114 au moins une couche adhésive au moins partiellement transparente, correspondant par exemple à une couche de colle polymère d'épaisseur par exemple comprise entre environ 1 µm et 100 µm.

D'autres moyens de collage peuvent également être envisagés pour réaliser la solidarisation du premier substrat 102 et des couches 104-110 avec le deuxième substrat 114, du moment que cette solidarisation forme une interface au moins partiellement transparente et ayant une force d'adhérence plus importante que celle formée entre les couches de séparation 104, 106.

Dans le premier mode de réalisation décrit ci-dessus, le dispositif 100 correspond à un dispositif de transduction piézoélectrique et la couche 108 comporte donc un matériau piézoélectrique au moins partiellement transparent. En variante, le dispositif 100 peut être configuré pour réaliser une transduction différente d'une transduction piézoélectrique. La nature du matériau utilisé pour la couche 108 est dans ce cas adaptée au type de transduction destinée à être réalisée par le dispositif 100. Il est par exemple possible que le matériau de la couche 108 soit un matériau pyroélectrique et/ou piézoélectrique et/ou ferroélectrique et/ou diélectrique. Selon une autre variante, le dispositif 100 peut correspondre à un composant autre qu'un dispositif de transduction, comme par exemple un condensateur ou une mémoire. La nature du matériau de la couche fonctionnelle 108 est dans tous les cas adaptée à la fonction devant être remplie par la couche fonctionnelle 108 (isolation, mémorisation, transduction, etc.).

Dans le premier mode de réalisation précédemment décrit, l'interface de faible force d'adhérence est formée grâce aux propriétés intrinsèques des matériaux des couches de séparation 104, 106, du fait que le SiO₂ et le nitrure de silicium adhérent peu aux métaux nobles. En variante, il est possible que la faible force d'adhérence de l'interface entre le substrat donneur (premier substrat 102) et les couches 108, 110 à transférer sur le substrat receveur (deuxième substrat 114) soit obtenue grâce à la mise en œuvre d'au moins une étape dégradant les propriétés d'adhérence de cette interface et réduisant la force d'adhérence à cette interface entre les matériaux des première et deuxième couches de séparation 104, 106. A titre d'exemple, lors du dépôt d'une couche 108 comportant du PZT sur la deuxième couche de séparation 106, il est possible de mettre en œuvre un traitement thermique faisant diffuser des atomes de plomb issus du PZT de la couche 108 vers le SiO₂ de l'une des couches de séparation 104, 106. Avec un tel traitement thermique, par exemple mis en œuvre à une température supérieure ou égale à environ 700°C, un mélange SiO₂ + Pb en phase liquide se forme à l'interface entre les première et deuxième couches de séparation 104, 106. Lorsque la température descend, des cavités se créent alors à cette interface, dans la couche formée du mélange de SiO₂ et de plomb. Ces cavités réduisent l'adhérence entre les couches de séparation 104, 106. La séparation mécanique réalisée ensuite est similaire à celle précédemment décrite.

Cette dégradation, ou réduction, de la force d'adhérence de l'interface entre les couches de séparation 104, 106 peut donc être avantageusement réalisée lorsque les propriétés intrinsèques des matériaux utilisés pour ces couches de séparation 104, 106 n'engendrent pas, sans intervention supplémentaire, la formation d'une interface de faible force d'adhérence.

Dans le premier mode de réalisation précédemment décrit, le deuxième substrat 114 au moins partiellementtransparent correspond à une couche de matériau non structurée. En variante, il est possible qu'une ou plusieurs cavités soient réalisées par gravure à travers au moins une partie de l'épaisseur du deuxième substrat 114, depuis une face arrière 120 de ce deuxième substrat 114, afin de conférer un certain degré de mobilité aux couches 108, 110, 118. La figure 2 représente le dispositif 100 selon cette variante de réalisation, la référence 122 désignant une cavité formée à travers une partie de l'épaisseur du deuxième substrat 114.

Un procédé de réalisation du dispositif 100 selon un deuxième mode de réalisation est décrit ci-dessous en lien avec les figures 3A à 3D.

Comme pour le premier mode de réalisation, les couches 104, 106 et 108 sont réalisées sur le premier substrat 102 (figure 3A). Toutefois, contrairement au premier mode de réalisation dans lequel la couche d'électrode 110 est formée sur la couche 108, aucune couche d'électrode n'est ici formée sur la couche 108. De plus, dans ce deuxième mode de réalisation, le collage entre les substrats 102, 114 sera réalisé par une couche adhésive. Ainsi, la couche de collage 112 n'est pas réalisée au sommet de l'empilement formé sur le premier substrat 102.

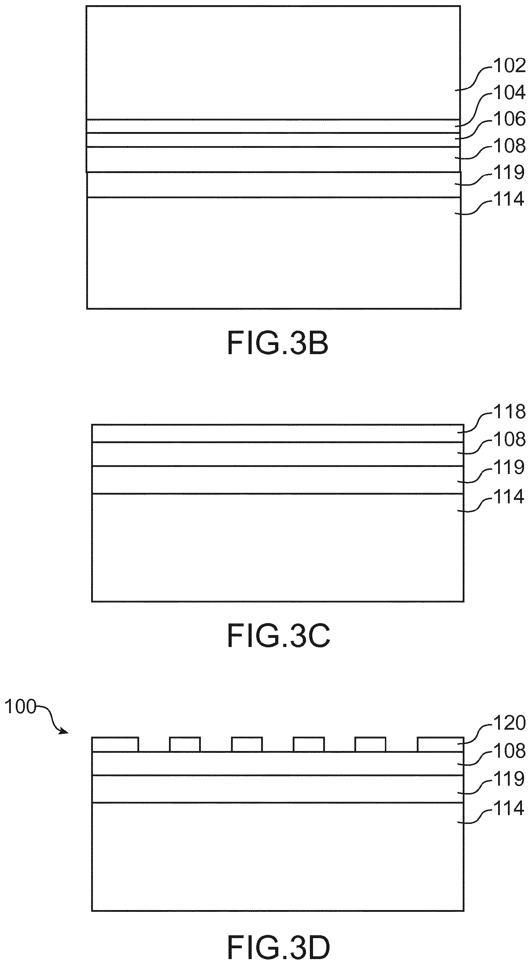

Les substrats 102, 114 sont solidarisés l'un à l'autre par l'intermédiaire d'une couche adhésive 119 formée sur le deuxième substrat 114 et à laquelle la couche 108 est solidarisée (figure 3B). La couche adhésive 119 comporte par exemple une colle polymère.

En variante ou en complément, la couche adhésive peut être réalisée sur la couche 108.

Une séparation mécanique est ensuite réalisée entre les couches de séparation 104, 106, puis la deuxième couche de séparation 106 est supprimée et la couche d'électrode 118 est réalisée sur la couche 108 (figure 3C).

Le dispositif 100 selon ce deuxième mode de réalisation est achevé en gravant la couche de l'électrode 118 afin que des portions restantes 120 de cette couche 118 forment, sur une seule face de la couche 108, les électrodes du dispositif 100 (figure 3D). Ces électrodes 120 forment par exemple des peignes interdigités.

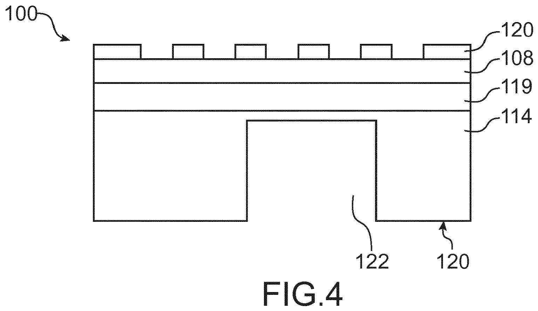

La figure 4 représente le dispositif 100 selon une variante du deuxième mode de réalisation, comprenant la cavité 122 formée à travers au moins une partie de l'épaisseur du deuxième substrat 114.

Les différents exemples de réalisation et les différentes variantes de réalisation décrits peuvent s'appliquer pour chacun des modes de réalisation.

## Revendications

1. Procédé de réalisation d'un dispositif (100) au moins partiellement transparent, comportant au moins :
- réalisation, sur une face d'un premier substrat (102), de première et deuxième couches de séparation (104, 106) disposées l'une contre l'autre et telles que la première couche de séparation (104) soit disposée entre le premier substrat (102) et la deuxième couche de séparation (106) ;
- réalisation, sur la deuxième couche de séparation (106), d'au moins une couche fonctionnelle (108) au moins partiellement transparente ;
- solidarisation de la couche fonctionnelle (108) à un deuxième substrat (114) au moins partiellement transparent, formant un empilement de différents matériaux ;
- séparation mécanique au niveau d'une interface entre les première et deuxième couches de séparation (104, 106), telle que la première couche de séparation (104) reste solidaire du premier substrat (102) et que la deuxième couche de séparation (106) reste solidaire de la couche fonctionnelle (108) ;
- suppression de la deuxième couche de séparation (106) ;
- réalisation d'au moins une première couche d'électrode (118) au moins partiellement transparente sur la couche fonctionnelle (108) ;
dans lequel les matériaux de l'empilement sont choisis tels que l'interface entre les première et deuxième couches de séparation (104, 106) correspond à celle, parmi toutes les interfaces de l'empilement, ayant la plus faible force d'adhérence, et dans lequel :
- l'une des première et deuxième couches de séparation (104, 106) comporte au moins du SiO₂ et/ou du nitrure de silicium et l'autre des première et deuxième couches de séparation (104, 106) comporte au moins un métal noble, et/ou
- le procédé comporte, entre l'étape de réalisation des première et deuxième couches de séparation (104, 106) et l'étape de solidarisation, la mise en œuvre d'au moins une étape réduisant une force d'adhérence initiale de l'interface entre les première et deuxième couches de séparation (104, 106).

2. Procédé selon la revendication 1, dans lequel le métal noble comporte du platine.

3. Procédé selon l'une des revendications précédentes, dans lequel l'étape de la solidarisation est mise en œuvre :
- par l'intermédiaire d'au moins une couche adhésive (119) au moins partiellement transparente réalisée sur la couche fonctionnelle (108) et/ou sur le deuxième substrat (114), ou
- par collage direct entre une première couche de collage (112) au moins partiellement transparente réalisée sur la couche fonctionnelle (108), et une deuxième couche de collage (116) au moins partiellement transparente réalisée sur le deuxième substrat (114).

4. Procédé selon la revendication 3, dans lequel :
- la couche adhésive (119) comporte une colle polymère, ou
- les première et deuxième couches de collage (112, 116) comportent du SiO₂.

5. Procédé selon l'une des revendications précédentes, dans lequel la couche fonctionnelle (108) comporte au moins un matériau pyroélectrique et/ou piézoélectrique et/ou ferroélectrique et/ou diélectrique.

6. Procédé selon la revendication 5, dans lequel :
- le matériau pyroélectrique et/ou piézoélectrique et/ou ferroélectrique et/ou diélectrique comporte du plomb ;
- ladite une des première et deuxième couches de séparation (104, 106) comporte du SiO₂ ;
- ladite au moins une étape réduisant la force d'adhérence initiale de l'interface entre les première et deuxième couches de séparation (104, 106) comporte la mise en œuvre d'au moins un traitement thermique formant, à l'interface entre les première et deuxième couches de séparation (104, 106), un alliage de plomb et de SiO₂ en phase liquide, puis d'un refroidissement formant des cavités à l'interface entre les première et deuxième couches de séparation (104, 106).

7. Procédé selon l'une des revendications précédentes, dans lequel :
- la première couche de séparation (104) comporte le métal noble, la deuxième couche de séparation (106) comporte du SiO₂ et/ou du nitrure de silicium, et la couche fonctionnelle (108) comporte de l'AIN, ou
- la première couche de séparation (104) comporte du SiO₂ et/ou du nitrure de silicium, la deuxième couche de séparation (106) comporte le métal noble et la couche fonctionnelle (108) comporte du PZT.

8. Procédé selon l'une des revendications précédente, comportant en outre, entre la réalisation de la couche fonctionnelle (108) et la solidarisation de la couche fonctionnelle (108) au deuxième substrat (114), la réalisation d'au moins une deuxième couche d'électrode (110) au moins partiellement transparente sur la couche fonctionnelle (108), et dans lequel, lors de l'étape de solidarisation, la deuxième couche d'électrode (110) est disposée entre le deuxième substrat (114) et la couche fonctionnelle (108).

9. Procédé selon l'une des revendications 1 à 7, comportant en outre, après la réalisation de la première couche d'électrode (118), une gravure de la première couche d'électrode (118) selon un motif de peignes interdigités et formant les électrodes du dispositif (100).

10. Procédé selon l'une des revendications précédentes, comprenant en outre, après l'étape de solidarisation, la réalisation d'au moins une cavité (122) dans le deuxième substrat (114), à travers une face opposée à celle sur laquelle la couche fonctionnelle (108) est solidarisée.

11. Procédé selon l'une des revendications 1 à 9, dans lequel le deuxième substrat (114) comporte au moins un matériau polymère, et dans lequel l'étape de solidarisation est mise en œuvre à une température inférieure ou égale à environ 150°C.

12. Dispositif (100) au moins partiellement transparent comportant au moins :
- un substrat (114) au moins partiellement transparent ;
- des première et deuxième couches d'électrode (110, 118) au moins partiellement transparentes disposées du côté d'une première face du substrat (114) et comprenant chacune au moins un matériau électriquement conducteur ;
- une couche fonctionnelle (108) au moins partiellement transparente, disposée entre et en contact direct avec les première et deuxième couches d'électrode (110, 118) ;
**caractérisé en ce qu'**il comporte en outre
au moins une cavité (122) traversant au moins une partie du substrat (114) depuis une deuxième face (120) du substrat (114) opposée à la première face.

13. Dispositif (100) selon la revendication 12, dans lequel :
- le substrat (114) comporte du verre et/ou au moins un matériau polymère, et/ou
- les première et deuxième couches d'électrodes (110, 118) comportent de l'ITO et/ou ZnO dopé avec du Ga et/ou du ZnO dopé avec de l'Al, et/ou
- la couche fonctionnelle (108) comporte au moins l'un des matériaux suivants : PZT, PMN-PT, KNN, NBT-BT, BaTiO₃.

## Patentansprüche

1. Verfahren zur Herstellung einer wenigstens teilweise transparenten Vorrichtung (100), umfassend wenigstens:
- Herstellen einer ersten und einer zweiten Trennschicht (104, 106) auf einer Seite eines ersten Substrats (102), die gegeneinander angeordnet sind, und derart, dass die erste Trennschicht (104) zwischen dem ersten Substrat (102) und der zweiten Trennschicht (106) angeordnet wird;
- Herstellen wenigstens einer wenigstens teilweise transparenten Funktionsschicht (108) auf der zweiten Trennschicht (106);
- Verbinden der Funktionsschicht (108) mit einem zweiten, wenigstens teilweise transparenten Substrat (114) unter Bildung eines Stapels unterschiedlicher Materialien;
- mechanisches Trennen an einer Grenzfläche zwischen der ersten und der zweiten Trennschicht (104, 106), so dass die erste Trennschicht (104) mit dem ersten Substrat (102) verbunden bleibt und die zweite Trennschicht (106) mit der Funktionsschicht (108) verbunden bleibt;
- Entfernen der zweiten Trennschicht (106);
- Herstellen wenigstens einer wenigstens teilweise transparenten ersten Elektrodenschicht (118) auf der Funktionsschicht (108);
wobei die Materialien des Stapels derart gewählt sind, dass die Grenzfläche zwischen der ersten und der zweiten Trennschicht (104, 106) derjenigen unter allen Grenzflächen des Stapels entspricht, die die geringste Haftkraft aufweist, und wobei:
- eine aus erster und zweiter Trennschicht (104, 106) wenigstens SiO₂ und/oder Siliziumnitrid umfasst und die andere aus erster und zweiter Trennschicht (104, 106) wenigstens ein Edelmetall umfasst, und/oder
- das Verfahren zwischen dem Schritt des Herstellens der ersten und zweiten Trennschicht (104, 106) und dem Schritt des Verbindens das Durchführen wenigstens eines Schritts umfasst, der eine anfängliche Haftkraft der Grenzfläche zwischen der ersten und zweiten Trennschicht (104, 106) reduziert.

2. Verfahren nach Anspruch 1, wobei das Edelmetall Platin umfasst.

3. Verfahren nach einem der vorhergehenden Ansprüche, wobei der Schritt des Verbindens durchgeführt wird:
- mittels wenigstens einer wenigstens teilweise transparenten Klebeschicht (119), die auf der Funktionsschicht (108) und/oder auf dem zweiten Substrat (114) hergestellt wird, oder
- direktes Kleben zwischen einer ersten, wenigstens teilweise transparenten Klebeschicht (112), die auf der Funktionsschicht (108) hergestellt wird und einer zweiten, wenigstens teilweise transparenten Klebeschicht (116), die auf dem zweiten Substrat (114) hergestellt wird.

4. Verfahren nach Anspruch 3, wobei:
- die Haftschicht (119) einen polymeren Klebstoff umfasst, oder
- die erste und zweite Klebeschicht (112, 116) SiO₂ umfassen.

5. Verfahren nach einem der vorhergehenden Ansprüche, wobei die Funktionsschicht (108) wenigstens ein pyroelektrisches und/oder piezoelektrisches und/oder ferroelektrisches und/oder dielektrisches Material umfasst.

6. Verfahren nach Anspruch 5, wobei:
- das pyroelektrische und/oder piezoelektrische und/oder ferroelektrische und/oder dielektrische Material Blei umfasst;
- die eine aus erster und zweiter Trennschicht (104, 106) SiO₂ umfasst;
- der wenigstens eine Schritt des Verringerns der anfänglichen Haftkraft der Grenzfläche zwischen der ersten und der zweiten Trennschicht (104, 106) das Durchführen wenigstens einer Wärmebehandlung umfasst, die an der Grenzfläche zwischen der ersten und der zweiten Trennschicht (104, 106) eine Legierung aus Blei und SiO₂ in einer flüssigen Phase bildet, gefolgt von einer Abkühlung, welche Hohlräume an der Grenzfläche zwischen der ersten und der zweiten Trennschicht (104, 106) bildet.

7. Verfahren nach einem der vorhergehenden Ansprüche, wobei:
- die erste Trennschicht (104) das Edelmetall umfasst, die zweite Trennschicht (106) SiO₂ und/oder Siliziumnitrid umfasst und die Funktionsschicht (108) aus AIN besteht, oder
- die erste Trennschicht (104) SiO₂ und/oder Siliziumnitrid umfasst, die zweite Trennschicht (106) das Edelmetall umfasst und die Funktionsschicht (108) PZT umfasst.

8. Verfahren nach einem der vorhergehenden Ansprüche, welches ferner zwischen der Herstellung der Funktionsschicht (108) und dem Verbinden der Funktionsschicht (108) mit dem zweiten Substrat (114) die Herstellung wenigstens einer wenigstens teilweise transparenten zweiten Elektrodenschicht (110) auf der Funktionsschicht (108) umfasst, und wobei während des Verbindungsschrittes die zweite Elektrodenschicht (110) zwischen dem zweiten Substrat (114) und der Funktionsschicht (108) angeordnet wird.

9. Verfahren nach einem der Ansprüche 1 bis 7, welches ferner nach der Herstellung, der ersten Elektrodenschicht (118) ein Ätzen der ersten Elektrodenschicht (118) mit einem ineinandergreifenden Kammmuster und Bilden der Elektroden der Vorrichtung (100) umfasst.

10. Verfahren nach einem der vorangehenden Ansprüche, welches ferner nach dem Schritt des Verbindens die Herstellung wenigstens eines Hohlraums (122) in dem zweiten Substrat (114) durch eine Seite, die derjenigen gegenüberliegt, an die die Funktionsschicht (108) gebunden ist, umfasst.

11. Verfahren nach einem der Ansprüche 1 bis 9, wobei das zweite Substrat (114) wenigstens ein polymeres Material umfasst, und wobei der Verbindungsschritt bei einer Temperatur von etwa 150°C oder weniger durchgeführt wird.

12. Wenigstens teilweise transparente Vorrichtung (100), umfassend wenigstens:
- ein wenigstens teilweise transparentes Substrat (114);
- eine erste und zweite wenigstens teilweise transparente Elektrodenschicht (110, 118), die neben einer ersten Seite des Substrats (114) angeordnet sind und jeweils wenigstens ein elektrisch leitendes Material umfassen;
- eine wenigstens teilweise transparente Funktionsschicht (108), die zwischen und in direktem Kontakt mit der ersten und der zweiten Elektrodenschicht (110, 118) angeordnet ist;
**dadurch gekennzeichnet, dass** sie ferner wenigstens einen Hohlraum (122) umfasst, der sich durch wenigstens einen Teil des Substrats (114) von einer zweiten Fläche (120) des Substrats (114) gegenüber der ersten Fläche erstreckt.

13. Vorrichtung (100) nach Anspruch 12, wobei:
- das Substrat (114) Glas und/oder wenigstens ein polymeres Material umfasst, und/oder
- die erste und zweite Elektrodenschicht (110, 118) ITO und/oder ZnO, dotiert mit GA und/oder ZnO, dotiert mit AI, umfassen, und/oder
- die Funktionsschicht (108) wenigstens eines der folgenden Materialien umfasst: PZT, PMN-PT, KNN, NBT-BT, BaTiO₃.

## Claims

1. Method for producing an at least partially transparent device (120), comprising at least:
- producing, on one face of a first substrate (102), first and second separation layers (104, 106) arranged one against the other and such that the first separation layer (104) is arranged between the first substrate (102) and the second separation layer (106);
- producing, on the second separation layer (106), at least one at least partially transparent functional layer (108);
- making the functional layer (108) integral with a second at least partially transparent substrate (114), forming a stack of different materials;
- mechanical separation at an interface between the first and second separation layers (104, 106), such that the first separation layer (104) remains integral with the first substrate (102) and that the second separation layer (106) remains integral with the functional layer (108);
- removal of the second separation layer (106);
- producing at least one first at least partially transparent electrode layer (118) on the functional layer (108);
in which the materials of the stack are chosen such that the interface between the first and second separation layers (104, 106) corresponds to that, among all the interfaces of the stack, having the lowest adherence force, and in which:
- one of the first and second separation layers (104, 106) comprises at least SiO₂ and/or silicon nitride, and the other of the first and second separation layers (104, 106) comprises at least one noble metal, and/or
- the method comprises, between the step of producing first and second separation layers (104, 106) and the making integral step, the implementation of at least one step reducing an initial adherence force of the interface between the first and second separation layers (104, 106).

2. Method according to claim 1, in which the noble metal comprises platinum.

3. Method according to one of previous claims, in which the making integral step is implemented:
- through at least one at least partially transparent adhesive layer (119) produced on the functional layer (108) and/or on the second substrate (114), or
- by direct bonding between a first at least partially transparent bonding layer (112) produced on the functional layer (108), and a second at least partially transparent bonding layer (116) produced on the second substrate (114).

4. Method according to claim 3, in which:
- the adhesive layer (119) comprises a polymer glue, or
- the first and second bonding layers (112, 116) comprise SiO₂.

5. Method according to one of previous claims, in which the functional layer (108) comprises at least one pyroelectric and/or piezoelectric and/or ferroelectric and/or dielectric material.

6. Method according to claim 5, in which:
- the pyroelectric and/or piezoelectric and/or ferroelectric and/or dielectric material comprises lead;
- said one of the first and second separation layers (104, 106) comprises SiO₂ ;
- said at least one step reducing the initial adherence force of the interface between the first and second separation layers (104, 106) comprises the implementation of at least one thermal treatment forming, at the interface between the first and second separation layers (104, 106), an alloy of lead and SiO₂ in liquid phase, then a cooling forming cavities at the interface between the first and second separation layers (104, 106).

7. Method according to one of previous claims, in which:
- the first separation layer (104) comprises the noble metal, the second separation layer (106) comprises SiO₂ and/or silicon nitride, and the functional layer (108) comprises AIN, or
- the first separation layer (104) comprises SiO₂ and/or silicon nitride, the second separation layer (106) comprises the noble metal and the functional layer (108) comprises PZT.

8. Method according to one of previous claims, further comprising, between the production of the functional layer (108) and making the functional layer (108) integral with the second substrate (114), the production of at least one second at least partially transparent electrode layer (110) on the functional layer (108), and in which, during the making integral step, the second electrode layer (110) is arranged between the second substrate (114) and the functional layer (108).

9. Method according to one of claims 1 to 7, further comprising, after the production of the first electrode layer (118), an etching of the first electrode layer (118) according to an interdigitated comb pattern and forming the electrodes of the device (100).

10. Method according to one of previous claims, further including, after the making integral step, the production of at least one cavity (122) in the second substrate (114), through a face opposite to that on which the functional layer (108) is made integral.

11. Method according to one of claims 1 to 9, in which the second substrate (114) comprises at least one polymer material, and in which the making integral step is implemented at a temperature less than or equal to around 150°C.

12. At least partially transparent device (100) comprising at least:
- an at least partially transparent substrate (114);
- first and second at least partially transparent electrode layers (110, 118) arranged on the side of a first face of the substrate (114) and each including at least one electrically conductive material;
- an at least partially transparent functional layer (108), arranged between and in direct contact with the first and second electrode layers (110, 118);
**characterized in that** it comprises
at least one cavity (122) crossing at least one part of the substrate (114) from a second face (120) of the substrate (114) opposite to the first face.

13. Device (100) according to claim 12, in which:
- the substrate (114) comprises glass and/or at least one polymer material, and/or
- the first and second electrode layers (110, 118) comprise ITO and/or ZnO doped with Ga and/or ZnO doped with Al, and/or
- the functional layer (108) comprises at least one of the following materials: PZT, PMN-PT, KNN, NBT-BT, BaTiO₃.
